# EUROPEAN PATENT APPLICATION

(11) **EP 2 575 015 A2**
(43) Date of publication of application: **03.04.2013**
(21) Application number: 12006644.4
(22) Date of filing: 21.09.2012
(51) Int. Cl.: G06F 3/044

(54) **Apparatus and method for sound control and electronic device**

(30) Priority: 30.09.2011 CN 201110299910; 10.09.2012 US 201213608474
(71) Applicant: Sony Mobile Communications AB, 221 88 Lund (SE)
(72) Inventor: Liu, Yinong, Chaoyang District 100102 Beijing (CN)
(74) Representative: Banzer, Hans-Jörg

(57) **Abstract**

The embodiments of the present invention provide an apparatus and method for sound control and an electronic device (1200), the apparatus for sound control including: contact keys (101) arranged in the sound output region; capacitive touch sensors (102) connected to the contact keys (101), the capacitance of the capacitive touch sensors (102) being changed when the contact keys (101) are contacted; and a sound controller (103) for generating sound control signals according to the changed capacitance of the capacitive touch sensors (102), so as to control the sound of the loudspeaker. With the embodiments of the present invention, the integration of the design may be improved, space saving may be facilitated, and better user experiences may be provided.

## Description

### Technical Field

The present invention relates to the field of electronics, and in particular to an apparatus and method for sound control, and an electronic device.

### Background Art

Currently, more and more electronic devices have a function of multimedia, especially for terminal equipment. Such terminal equipment has not only a loudspeaker and a sound output region of the loudspeaker, but also a control key for controlling the sound, which is capable of controlling the play, pause, forward, backward and muting of the sound.

### Summary of the invention

In the implementation of the present invention, this applicant found that in the prior art, the sound output region of a terminal equipment is arranged separately from the sound control key, which is disadvantageous to space saving, nor can provide users with better experiences.

The embodiments of the present invention provide an apparatus and method for sound control, and electronic device, with the objective being to combine a sound output region and a sound control key, so as to improve the integration of the design and provide better user experiences.

According to an aspect of the embodiments of the present invention, there is provided an apparatus for sound control, applicable to a sound output region of a loudspeaker, the apparatus for sound control including:
contact keys arranged in the sound output region;
capacitive touch sensors connected to the contact keys, the capacitance of the capacitive touch sensors being changed when the contact keys are contacted; and
a sound controller for generating sound control signals according to the changed capacitance of the capacitive touch sensors, so as to control the sound of the loudspeaker.

According to another aspect of the embodiments of the present invention, the contact keys are multiple, with output holes of the loudspeaker being provided between the contact keys; and
the capacitive touch sensors are multiple, with each of the capacitive touch sensors being connected to one or more of the contact keys.

According to a further aspect of the embodiments of the present invention, the sound controller controls the stop or muting of the sound according to the time interval of the change of the capacitance of the capacitive touch sensors.

According to still another aspect of the embodiments of the present invention, the sound controller controls the pause, play, backward or forward of the sound according to the changes of capacitance of different capacitive touch sensors of the multiple capacitive touch sensors.

According to still another aspect of the embodiments of the present invention, the sound controller controls the volume of the sound according to the change of capacitance of the capacitive touch sensors.

According to still another aspect of the embodiments of the present invention, the width of the contact keys is 2.5mm, the length of the contact keys is 8.0mm, and the width of the output hole is 1.0mm.

According to still another aspect of the embodiments of the present invention, there is provided an electronic device, having an output region of a loudspeaker, the electronic device including the apparatus for sound control as described above.

According to still another aspect of the embodiments of the present invention, there is provided a method for sound control, applicable to a sound output region of a loudspeaker, the method for sound control including:
a capacitance changing step of contacting contact keys arranged in the sound output region so that the capacitance of capacitive touch sensors connected to the contact keys are changed; and
a sound controlling step of generating sound control signals according to the changed capacitance of the capacitive touch sensors, so as to control the sound of the loudspeaker.

According to still another aspect of the embodiments of the present invention, the contact keys are multiple, with output holes of the loudspeaker being provided between the contact keys; and
the capacitive touch sensors are multiple, with each of the capacitive touch sensors being connected to one or more of the contact keys.

According to still another aspect of the embodiments of the present invention, the sound controlling step includes a step of controlling the stop or muting of the sound according to the time interval of the change of the capacitance of the capacitive touch sensors.

According to still another aspect of the embodiments of the present invention, the sound controlling step includes a step of controlling the pause, play, backward or forward of the sound according to the changes of capacitance of different capacitive touch sensors of the multiple capacitive touch sensors.

According to still another aspect of the embodiments of the present invention, the sound controlling step includes a step of controlling the volume of the sound according to the change of capacitance of the capacitive touch sensors.

The advantages of the embodiments of the present invention exist in that, by setting up contact keys in the sound control region, control signals for controlling the sound are generated when the contact keys are contacted and the capacitance of the capacitive touch sensors are changed, thereby improving the integration of the design, facilitating space saving, and providing better user experiences.

These and further aspects and features of the present invention will be apparent with reference to the following description and attached drawings. In the description and drawings, particular embodiments of the invention have been disclosed in detail as being indicative of some of the ways in which the principles of the invention may be employed, but it is understood that the invention is not limited correspondingly in scope. Rather, the invention includes all changes, modifications and equivalents coming within the spirit and terms of the appended claims.

Features that are described and/or illustrated with respect to one embodiment may be used in the same way or in a similar way in one or more other embodiments and/or in combination with or instead of the features of the other embodiments.

It should be emphasized that the term "includes/including" when used in this specification is taken to specify the presence of stated features, integers, steps or components but does not preclude the presence or addition of one or more other features, integers, steps, components or groups thereof.

Many aspects of the invention can be better understood with reference to the following drawings. The components in the drawings are not necessarily to scale, emphasis instead being placed upon clearly illustrating the principles of the present invention. To facilitate illustrating and describing some parts of the invention, corresponding portions of the drawings may be exaggerated in size, e.g., made larger in relation to other parts than in an exemplary device actually made according to the invention. Elements and features depicted in one drawing or embodiment of the invention may be combined with elements and features depicted in one or more additional drawings or embodiments. Moreover, in the drawings, like reference numerals designate corresponding parts throughout the several views and may be used to designate like or similar parts in more than one embodiment.

### Brief Description of the Drawings

The drawings are included to provide further understanding of the present invention, which constitute a part of the specification and illustrate the preferred embodiments of the present invention, and are used for setting forth the principles of the present invention together with the description. The same element is represented with the same reference number throughout the drawings.

In the drawings:
Figure 1 is a schematic diagram of the structure of the sound control apparatus in accordance with the embodiments of the present invention;
Figure 2 is a schematic diagram of the arrangement of the contact keys in accordance with the embodiments of the present invention;
Figure 3 is a side view of the arrangement of the contact keys in accordance with the embodiments of the present invention;
Figure 4 is a schematic diagram of the connection of the contact keys and capacitive touch sensors in accordance with the embodiments of the present invention;
Figure 5 is a schematic diagram of performing the function of play/pause in accordance with the embodiments of the present invention;
Figure 6 is a schematic diagram of performing the function of backward in accordance with the embodiments of the present invention;
Figure 7 is a schematic diagram of performing the function of forward in accordance with the embodiments of the present invention;
Figure 8 is a schematic diagram of performing the function of volume up in accordance with the embodiments of the present invention;
Figure 9 is a schematic diagram of performing the function of volume down in accordance with the embodiments of the present invention;
Figure 10 is another schematic diagram of the arrangement of the contact keys in accordance with the embodiments of the present invention;
Figure 11 is a flowchart of the method for sound control in accordance with the embodiments of the present invention; and
Figure 12 is schematic block diagram of the electronic device in accordance with the embodiments of the present invention.

### Detailed Description of the Invention

The interchangeable terms "electronic device" and "electronic apparatus" include portable radio communication apparatus. The term "portable radio communication apparatus", which hereinafter is referred to as a "mobile terminal", "portable electronic device", or "portable communication device", includes all apparatuses such as mobile telephones, pagers, communicators, electronic organizers, personal digital assistants (PDAs), smartphones, portable communication devices or the like.

In the present application, embodiments of the invention are described primarily in the context of a portable electronic device in the form of a mobile telephone (also referred to as "mobile phone"). However, it shall be appreciated that the invention is not limited to the context of a mobile telephone and may relate to any type of appropriate electronic device having the function of photographing and sound recording.

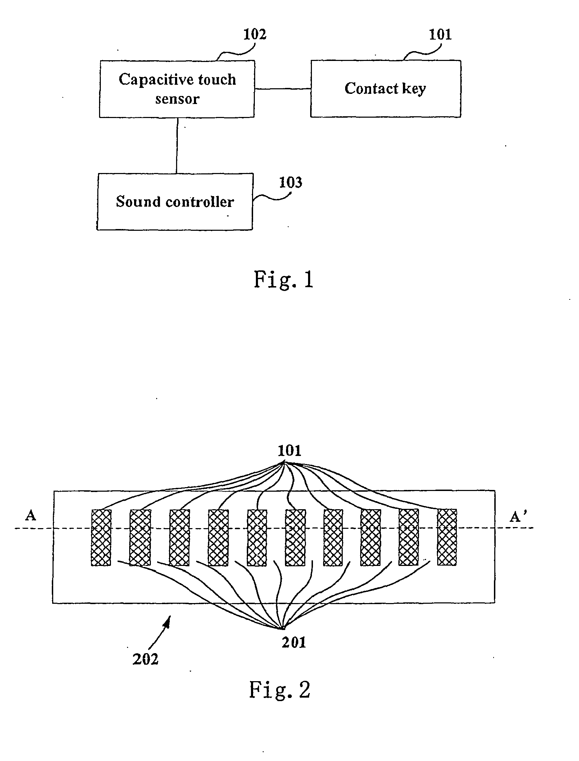

The embodiments of the invention provide an apparatus for sound control, applicable to a sound output region of a loudspeaker. Fig. 1 is a schematic diagram of the structure of the sound control apparatus of the embodiments of the present invention. As shown in Fig. 1, the apparatus for sound control includes: contact keys 101, capacitive touch sensors 102 and a sound controller 103.

The contact keys 101 are arranged in the sound output region; the capacitive touch sensors 102 are connected to the contact keys 101, with the capacitance of the capacitive touch sensors 102 being changed through the contact keys 101 that are contacted; and the sound controller 103 generates sound control signals in accordance with the changed capacitance of the capacitive touch sensors 102, so as to control the sound of the loudspeaker.

In particular implementations, the contact keys 101 may be of a metal structure and connected to the capacitive touch sensors 102. When a finger of a user contacts the contact keys, capacitance are formed between the finger and the contact keys due to the electrical field of the human body, as the tissues of the skin of the human body are full of conductive electrolytes, thereby changing the capacitance of the capacitive sensors. As to the working principle and specific operations of the capacitive sensors, the prior art may be referred to, which shall not be described any further.

In an embodiment, there may be only one contact key 101 connected to one capacitive touch sensor 102. When a finger of a user contacts the contact key 101, the capacitance of the capacitive touch sensor 102 is changed, thus, the sound controller 103 may generate a control signal for playing the sound; and when the finger contacts the contact key 101 again, the sound controller 103 may generate a control signal for stopping the sound.

In another embodiment, the sound controller 103 may control the sound in accordance with the time interval of the change of the capacitance of the capacitive touch sensor 102.

For example, when the user double clicks the contact key 101 (contacts the contact key 101 twice, with a time interval of, for example, 0.2 second), the sound controller 103 may generate a control signal for muting the sound according to the time interval of the change of the capacitance (such as the time intervals of the first-time capacitance from low to high and again to low, and the second-time capacitance from low to high and again to low).

When the user contacts the contact key 101 for a long time (such as more than one second), the sound controller 103 may generate a control signal for stopping the sound according to the time interval of the change of the capacitance (for example, a time interval with the capacitance maintained high during the process of the capacitance changing from low to high and again to low).

What is described above is exemplary only, and the present invention is not limited thereto, and may be designed according to the user practice. For example, turning on a multimedia player may be defined by spacing apart two fingers on the contact keys array; and turning off a multimedia player may be defined by keeping two fingers close to each other. Particular embodiments may be determined as actually demanded.

In particular implementations, it is preferable that the contact keys 101 may be multiple, with output holes of the loudspeaker being provided between the contact keys; and the capacitive touch sensors 102 may also be multiple, with each of the capacitive touch sensors being connected to one or more of the contact keys.

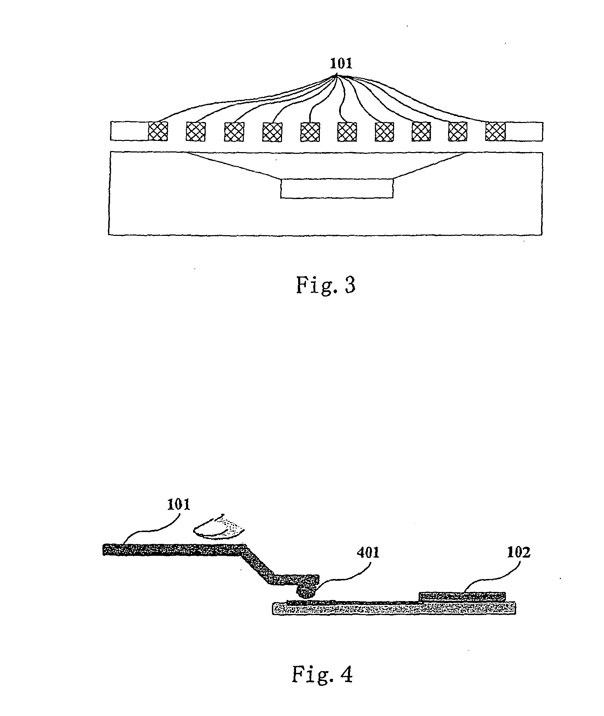

Fig. 2 is a schematic diagram of the arrangement of the contact keys in accordance with the embodiments of the present invention, and Fig. 3 is a sectional view taking along line A-A' in Fig. 2. As shown in Figs. 2 and 3, multiple contact keys 101 may be arranged in the sound output region 202, with output holes 201 being provided between the contact keys. Thus, not only the sound output region may be decorated, but also the integration of the design may be improved, facilitating space saving.

Fig. 4 is a schematic diagram of the connection of the contact keys and capacitive touch sensors in accordance with the embodiments of the present invention. As shown in Fig. 4, the contact keys 101 may be connected to the capacitive touch sensors 102 via contact points 401, thereby ensuring a reliable connection.

In particular implementations, the sound controller 103 may generate control signals, for example, to pause, play, backward, or forward the sound, according to the changes of capacitance of different capacitive touch sensors in the multiple capacitive touch sensors.

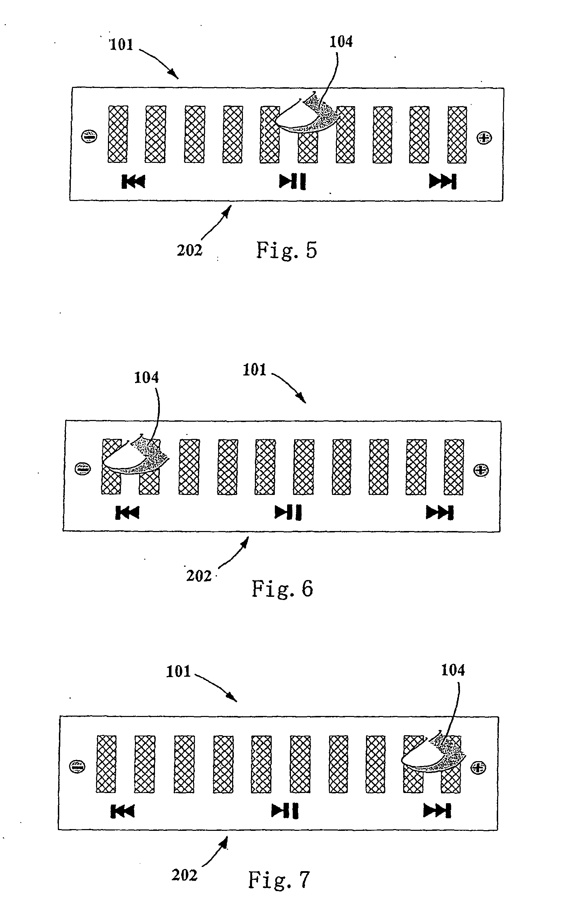

Figs. 5-7 show different sound control performed at different positions. Wherein, Fig. 5 is a schematic diagram of performing the function of play/pause in accordance with the embodiments of the present invention, Fig. 6 is a schematic diagram of performing the function of backward in accordance with the embodiments of the present invention. Fig. 7 is a schematic diagram of performing the function of forward in accordance with the embodiments of the present invention.

As shown in Fig. 5, for multiple contact keys 101, one or more contact keys located at the center may be contacted (such as single-click), such that the capacitance of one or more capacitive touch sensors 102 connected with the one or more contact keys is changed, thereby a control signal for playing sound is generated by the sound controller 103; and when the one or more contact keys are contacted by the finger 104 of the user again, the sound controller 103 may generate a control signal for pausing the sound.

As shown in Fig. 6, for multiple contact keys 101, one or more contact keys located at one end (such as at the leftmost end) may be contacted (such as single-click), such that the capacitance of one or more capacitive touch sensors 102 connected with the one or more contact keys is changed, thereby a control signal for backward of sound is generated by the sound controller 103.

As shown in Fig. 7, for multiple contact keys 101, one or more contact keys located at another end (such as at the rightmost end) may be contacted (such as single-click), such that the capacitance of one or more capacitive touch sensors connected with the one or more contact keys is changed, thereby a control signal for forward of sound is generated by the sound controller 103.

In particular implementations, the sound controller 103 may further control the volume of the sound according to the change of capacitance of multiple capacitive touch sensors.

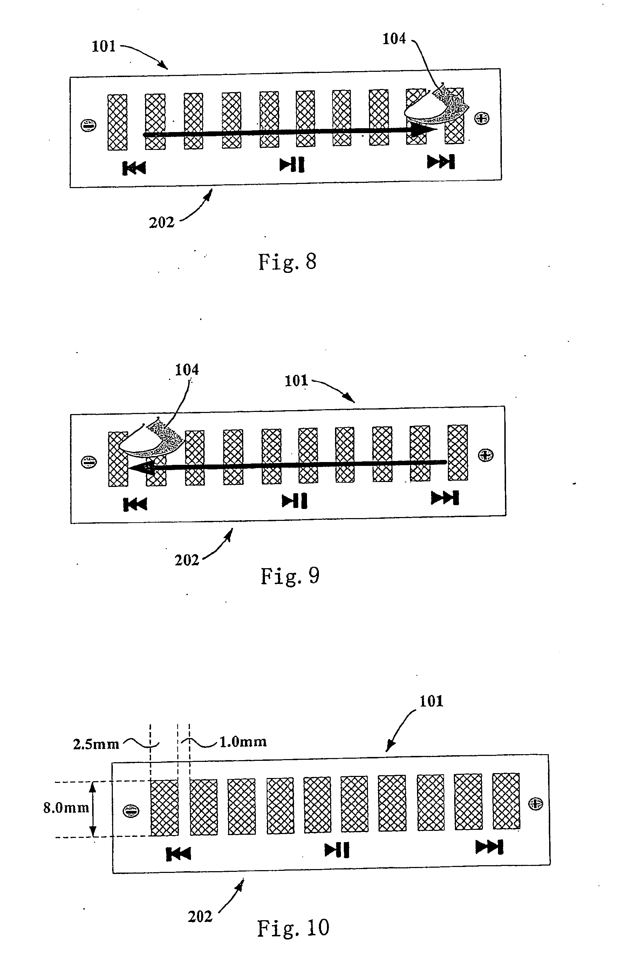

Figs. 8 and 9 show the sound control by moving a finger 104 on multiple contact keys 101. Fig. 8 is a schematic diagram of performing the function of volume up in accordance with the embodiments of the present invention, and Fig. 9 is a schematic diagram of performing the function of volume down in accordance with the embodiments of the present invention.

As shown in Fig. 8, a user may move his finger 104 on multiple contact keys 101 from the left to the right, thereby contacting the multiple contact keys from the left to the right and changing the capacitance of multiple capacitive touch sensors 102 connected to the multiple contact keys in turn (for example, the capacitance of the capacitive touch sensor connected to the leftmost contact key is changed from low to high and again to low, and then the capacitance of the capacitive touch sensor connected to the next contact key is changed from low to high and again to low,... at last the capacitance of the capacitive touch sensor connected to the rightmost contact key is changed from low to high and again to low), and the sound controller 103 may generate a control signal for volume up according to the above changes of capacitance.

As shown in Fig. 9, a user may move his finger 104 on multiple contact keys 101 from the right to the left, thereby contacting the multiple contact keys from the right to the left and changing the capacitance of multiple capacitive touch sensors 102 connected to the multiple contact keys in turn (for example, the capacitance of the capacitive touch sensor connected to the rightmost contact key is changed from low to high and again to low, and then the capacitance of the capacitive touch sensor connected to the next contact key is changed from low to high and again to low,... at last the capacitance of the capacitive touch sensor connected to the leftmost contact key is changed from low to high and again to low), and the sound controller 103 may generate a control signal for volume down according to the above changes of capacitance.

It should be noted that the above description is exemplary only, and the present invention is not limited thereto. For example, a control signal for stopping the sound may be generated after a user double clicks a contact key 101 , and particular setup modes may be determined as actually demanded.

Hence, the user may not only control the sound by single-click or double-click, but also control the volume adjustment by moving in the sound output region, realizing the sound control like playing piano, thereby improving greatly the user experience.

Fig. 10 is another schematic diagram of the arrangement of the contact keys 101 in accordance with the embodiments of the present invention. As shown in Fig. 10, it is preferable that the width of each of the contact keys is 2.5mm, and the length is 8.0mm, and the width of an output hole is 1.0mm. From the viewpoint of implementation, the above setting may not only save space, but also have no effect on the implementation of functions.

It can be seen from the above embodiment that, by setting up contact keys 101 in the sound control region, control signals for controlling the sound are generated when the contact keys are contacted and the capacitance of the capacitive touch sensors are changed, thereby improving the integration of the design, facilitating space saving, and providing better user experiences.

The embodiments of the present invention further provide a method for sound control, applicable to a sound output region 202 of a loudspeaker, with the contents being similar to those described above, which shall not be described any further.

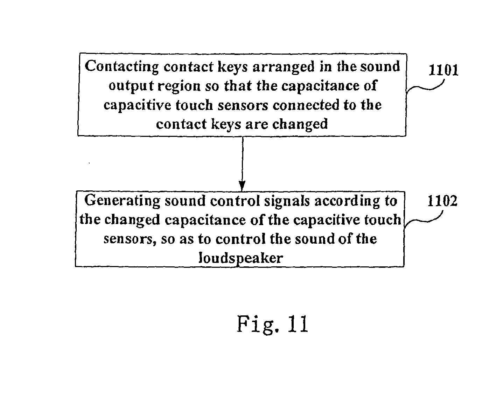

Fig. 11 is a flowchart of the method for sound control in accordance with the embodiments of the present invention. As shown in Fig. 11, the method for sound control includes:
a capacitance changing step 1101 of contacting contact keys arranged in the sound output region so that the capacitance of capacitive touch sensors connected to the contact keys are changed; and
a sound controlling step 1102 of generating sound control signals according to the changed capacitance of the capacitive touch sensors, so as to control the sound of the loudspeaker.

Furthermore, the sound controlling step 1102 includes a step of controlling the stop or muting of the sound according to the time interval of the change of the capacitance of the capacitive touch sensors.

In particular implementations, it is preferable that the contact keys 101 are multiple, with output holes 201 of the loudspeaker being provided between the contact keys; and the capacitive touch sensors 102 are multiple, with each of the capacitive touch sensors being connected to one or more of the contact keys.

Furthermore, the sound controlling step 1102 includes a step of controlling the pause, play, backward or forward of the sound according to the changes of capacitance of different capacitive touch sensors 102 among the multiple capacitive touch sensors.

Furthermore, the sound controlling step 1102 includes a step of controlling the volume of the sound according to the change of capacitance of the capacitive touch sensors 102.

It can be seen from the above embodiment that, by setting up contact keys 101 in the sound control region 202, control signals for controlling the sound are generated when the contact keys are contacted and the capacitance of the capacitive touch sensors 102 are changed, thereby improving the integration of the design, facilitating space saving, and providing better user experiences.

The embodiments of the present invention also provide an electronic device, which includes the sound detection device as described above.

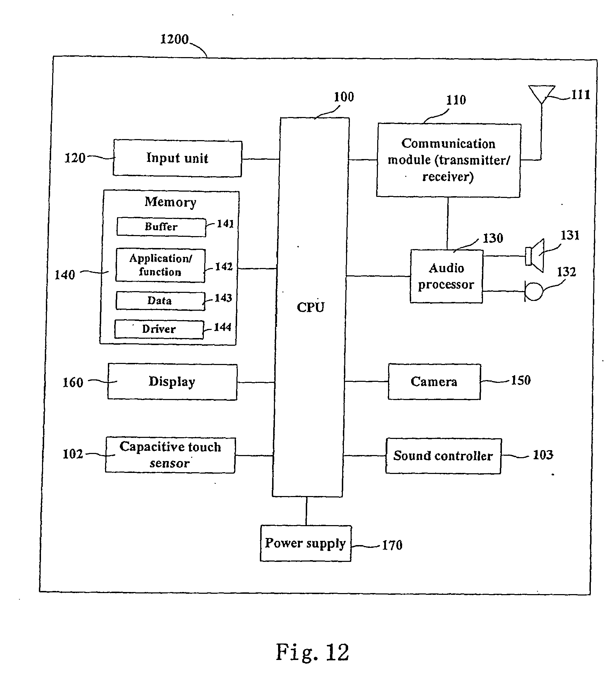

Fig. 12 is schematic block diagram of the electronic device 1200 in accordance with the embodiments of the present invention, which includes the above-described capacitive touch sensors 102 and sound controller 103, with the contact keys 101 being not shown in this figure. Such a figure is exemplary, and other types of structures may be used for supplementing or replacing this structure, so as to realized telecommunications functions or other functions.

As shown in fig. 12, the electronic device 1200 includes a central processing unit 100, a communication module 110, an input unit 120, an audio processing unit 130, a memory 140, a camera 150, a display 160, and a power supply 170.

The capacitive touch sensors 102 and sound controller 103 may be connected directly, may be connected via the central processing unit 100 shown in Fig. 12, and may also be integrated into the central processing unit 100.

The central processing unit 100 (sometimes referred to as a controller or control unit, which may include a microprocessor or other processor devices and/or logic devices) receives input and controls every components and operations of the electronic device 1200. The input unit 120 provides input to the central processing unit 100. The input unit 120 is, for example, a key or a touch input device. The camera 150 is used to pick up image data and provide the image data to the central processing unit 100, for use in a conventional manner, such as storage, and transmission, etc.

The power supply 170 is used to supply electric power to the electronic device 1200. The display 160 is used to display the display objects, such as images, and characters, etc. The display may be, for example, an LCD display, but it is not limited thereto.

The memory 140 is coupled to the central processing unit 100. The memory 140 may be a solid-state memory, such as a read-only memory (ROM), a random access memory (RAM), and a SIM card, etc. It may also be such a memory that stores information when the power is interrupted, may be optionally erased and provided with more data. Examples of such a memory are sometimes referred to as an EPROM, etc. The memory 140 may also be certain other types of devices. The memory 140 includes a buffer memory 141 (sometimes referred to as a buffer). The memory 140 may comprise an application/function storing portion 142 used to store application programs and function programs, or to execute the flow of the operation of the electronic device 1200 via the central processing unit 100.

The memory 140 may further comprise a data storing portion 143 used to store data, such as a contact person, digital data, pictures, voices and/or any other data used by the electronic device. A driver storing portion 144 of the memory 140 may comprise various types of drivers of the electronic device for the communication function and/or for executing other functions (such as application of message transmission, and application of directory, etc.) of the electronic device.

The communication module 110 is a transmitter/receiver 110 transmitting and receiving signals via an antenna 111. The communication module (transmitter/receiver) 110 is coupled to the central processing unit 100 to provide input signals and receive output signals, this being similar to the case in a conventional mobile phone.

A plurality of communication modules 110 may be provided in the same electronic device for various communication technologies, such a cellular network module, a Bluetooth module, and/or wireless local network module, etc. The communication module (transmitter/receiver) 110 is also coupled to a loudspeaker 131 and a microphone 132 via the audio processing unit 130, for providing audio output via the loudspeaker 131 and receiving the audio input from the microphone 132, thereby achieving common telecommunications functions. The audio processing unit 130 may comprise any appropriate buffers, decoders, and amplifiers, etc. The audio processing unit 130 is further coupled to the central processing unit 100, thereby enabling the recording of voices in this device via the microphone 132 and the playing of the voices stored in this device via the loudspeaker 131.

The preferred embodiments of the present invention are described above with reference to the drawings. The many features and advantages of the embodiments are apparent from the detailed specification and, thus, it is intended by the appended claims to cover all such features and advantages of the embodiments that fall within the true spirit and scope thereof. Further, since numerous modifications and changes will readily occur to those skilled in the art, it is not desired to limit the inventive embodiments to the exact construction and operation illustrated and described, and accordingly all suitable modifications and equivalents may be resorted to, falling within the scope thereof.

It should be understood that each of the parts of the present invention may be implemented by hardware, software, firmware, or a combination thereof. In the above embodiments, multiple steps or methods may be realized by software or firmware that is stored in the memory and executed by an appropriate instruction executing system. For example, if it is realized by hardware, it may be realized by any one of the following technologies known in the art or a combination thereof as in another embodiment: a discrete logic circuit having a logic gate circuit for realizing logic functions of data signals, application-specific integrated circuit having an appropriate combined logic gate circuit, a programmable gate array (PGA), and a field programmable gate array (FPGA), etc.

The description or blocks in the flowcharts or of any process or method in other manners may be understood as being indicative of including one or more modules, segments or parts for realizing the codes of executable instructions of the steps in specific logic functions or processes, and that the scope of the preferred embodiments of the present invention include other implementations, wherein the functions may be executed in manners different from those shown or discussed, including executing the functions according to the related functions in a substantially simultaneous manner or in a reverse order, which should be understood by those skilled in the art to which the present invention pertains.

The logic and/or steps shown in the flowcharts or described in other manners here may be, for example, understood as a sequencing list of executable instructions for realizing logic functions, which may be implemented in any computer readable medium, for use by an instruction executing system, device or apparatus (such as a system including a computer, a system including a processor, or other systems capable of extracting instructions from an instruction executing system, device or apparatus and executing the instructions), or for use in combination with the instruction executing system, device or apparatus.

The above literal description and drawings show various features of the present invention. It should be understood that those skilled in the art may prepare appropriate computer code to carry out each of the steps and processes as described above and shown in the drawings. It should be also understood that all the terminals, computers, servers, and networks may be any type, and the computer code may be prepared according to the disclosure to carry out the present invention by using the apparatus.

Particular embodiments of the present invention have been disclosed herein. Those skilled in the art will readily recognize that the present invention is applicable in other environments. In practice, there exist many embodiments and implementations. The appended claims are by no means intended to limit the scope of the present invention to the above particular embodiments. Furthermore, any reference to "a device to..." is an explanation of device plus function for describing elements and claims, and it is not desired that any element using no reference to "a device to..." is understood as an element of device plus function, even though the wording of "device" is included in that claim.

Although a particular preferred embodiment or embodiments have been shown and the present invention has been described, it is obvious that equivalent modifications and variants are conceivable to those skilled in the art in reading and understanding the description and drawings. Especially for various functions executed by the above elements (portions, assemblies, apparatus, and compositions, etc.), except otherwise specified, it is desirable that the terms (including the reference to "device") describing these elements correspond to any element executing particular functions of these elements (i.e. functional equivalents), even though the element is different from that executing the function of an exemplary embodiment or embodiments illustrated in the present invention with respect to structure. Furthermore, although the a particular feature of the present invention is described with respect to only one or more of the illustrated embodiments, such a feature may be combined with one or more other features of other embodiments as desired and in consideration of advantageous aspects of any given or particular application.

## Claims

1. An apparatus for sound control, applicable to a sound output region of a loudspeaker (131), the apparatus for sound control comprising:
contact keys (101) arranged in the sound output region;
capacitive touch sensors (102) connected to the contact keys (101), the capacitance of the capacitive touch sensors (102) being changed when the contact keys (101) are contacted; and
a sound controller (103) for generating sound control signals according to the changed capacitance of the capacitive touch sensors (102), so as to control the sound of the loudspeaker(131).

2. The apparatus for sound control according to claim 1, wherein the contact keys (101) are multiple, with output holes (201) of the loudspeaker (131) being provided between the contact keys (101); and
the capacitive touch sensors (102) are multiple, with each of the capacitive touch sensors (102) being connected to one or more of the contact keys (101).

3. The apparatus for sound control according to either one of claims 1 or 2, wherein the sound controller (103) controls the stop or muting of the sound according to the time interval of the change of the capacitance of the capacitive touch sensors (102).

4. The apparatus for sound control according to any one of claims 1-3, wherein the sound controller (103) controls the pause, play, backward or forward of the sound according to the changes of capacitance of different capacitive touch sensors (102) of the multiple capacitive touch sensors (102).

5. The apparatus for sound control according to any one of claims 1-3, wherein the sound controller (103) controls the volume of the sound according to the change of capacitance of the capacitive touch sensors (102).

6. The apparatus for sound control according to any one of claims 1-5, wherein the width of the contact keys (101) is about 2.5mm, the length of the contact keys (101) is about 8.0mm, and the width of the output hole is about 1.0mm.

7. An electronic device (1200), having an output region of a loudspeaker (131), the electronic device (1200) comprising the apparatus for sound control as claimed in any one of claims 1-6.

8. A method for sound control, applicable to a sound output region of a loudspeaker (131), the method for sound control comprising:
a capacitance changing step (1101) of contacting contact keys (101) arranged in the sound output region so that the capacitance of capacitive touch sensors (102) connected to the contact keys (101) are changed; and
a sound controlling step (1102) of generating sound control signals according to the changed capacitance of the capacitive touch sensors (102), so as to control the sound of the loudspeaker.

9. The method for sound control according to claim 8, wherein the contact keys (101) are multiple, with output holes (201) of the loudspeaker being provided between the contact keys (101); and
the capacitive touch sensors (102) are multiple, with each of the capacitive touch sensors (102) being connected to one or more of the contact keys (101).

10. The method for sound control according to either one of claims 8 or 9 wherein the sound controlling step (1102) comprises a step of controlling the stop or muting of the sound according to the time interval of the change of the capacitance of the capacitive touch sensors (102).

11. The method for sound control according to any one of claims 8-10, wherein the sound controlling step (1102) comprises a step of controlling the pause, play, backward or forward of the sound according to the changes of capacitance of different capacitive touch sensors (102) among the multiple capacitive touch sensors (102).

12. The method for sound control according to any one of claims 8-11, wherein the sound controlling step (1102) comprises a step of controlling the volume of the sound according to the change of capacitance of the capacitive touch sensors (102).
